# EUROPÄISCHE PATENTSCHRIFT

(11) **EP 1 345 034 B1**
(45) Veröffentlichungstag und Bekanntmachung des Hinweises auf die Patenterteilung: **23.04.2008**
(21) Anmeldenummer: 03001155.5
(22) Anmeldetag: 21.01.2003
(51) Int. Cl.: G01R 31/02, G01R 31/00, G01R 29/08

(54) **Messtisch**
Measuring table
Table de mesure

(30) Priorität: 13.03.2002 DE 10211219
(43) Veröffentlichungstag der Anmeldung: 17.09.2003
(73) Patentinhaber: ROBERT BOSCH GMBH, 70442 Stuttgart (DE)
(72) Erfinder: Pfaff, Wolfgang, 71686 Remseck-Aldingen (DE); Schuetze, Wolfgang, 71665 Vaihingen (DE); Goldberg, Artur, 74343 Sachsenheim (DE)

(56) Entgegenhaltungen:
- FR-A- 2 801 983
- US-A- 5 982 331
- US-B1- 6 184 693

## Beschreibung

### Stand der Technik

Die Erfindung betrifft einen Meßtisch mit den im Oberbegriff des Anspruchs 1 genannten Merkmalen.

Es ist bekannt, z.B. aus der FR 2 801 983, der US 6 184 693 oder der US 5 982 331 zur Messung der elektromagnetischen Verträglichkeit (EMV) von elektronischen Bauteilen oder Bauteilgruppen einerseits Messungen der Störfestigkeit des Bauteils oder der Bauteilgruppe gegenüber elektromagnetischen Feldern (Einstrahlungsmessung) und andererseits Messungen der von dem Bauteil oder der Bauteilgruppe ausgesandten elektromagnetischen Störstrahlung durchzuführen. Im Stand der Technik wird zur Einstrahlungsmessung ein erster Meßtisch mit einer Streifenleiterstruktur (Stripline) und einer elektrisch leitfähigen Tischplatte verwandt. Zur Durchführung einer davon verschiedenen Antennenabstrahlungs- und/ oder Antenneneinstrahlungsmessung wird ein zweiter Meßtisch mit einer leitfähigen Tischplatte ohne Streifenleiterstruktur verwandt, auf dem Vorrichtungen für Antennenmessungen angeordnet werden können. Für alle Messungen sind bestimmte Maße des Tisches, sowie, bei Messungen mit der Streifenleiterstruktur, bestimmte Abmessungen der Streifenleiter vorgeschrieben, welche beispielsweise den Normen IEC/CISPR 25 und ISO 11452 Teil 2 und 5 entsprechen. Beide Meßtische sind recht groß und weisen einen nicht unerheblichen Platzbedarf auf, was insbesondere deshalb problematisch ist, weil die Messungen nur in speziell abgeschirmten Räumen mit Hochfrequenzabsorbern, sogenannten Absorberräumen durchgeführt werden können.

### Vorteile der Erfindung

Der erfindungsgemäße Meßtisch mit dem kennzeichnenden Merkmal des Anspruchs 1 ermöglicht es vorteilhaft, mit dem gleichen Meßtisch elektromagnetische Verträglichkeitsmessungen einer ersten Art und elektromagnetische Verträglichkeitsmessungen einer zweiten Art durchzuführen. So ist es beispielsweise möglich, mit dem gleichen Meßtisch die Streifenleitermessung und die Antenneneinstrahlungs- und Antennenabstrahlungsmessung durchzuführen. Durch die Einsparung eines Meßtisches kann der benötigte Absorberraum vorteilhaft verkleinert werden, was mit einer erheblichen Kostenersparnis verbunden ist.

Weiterentwicklungen und vorteilhafte Ausführungsbeispiele der Erfindung sind in den nachgeordneten Ansprüchen beschrieben.

Besonders vorteilhaft ist es, die Tischplatte an einem Tischgestell schwenkbar zu lagern. Das Tischgestell kann auf Rollen fahrbar montiert werden, oder aber die Tischplatte kann relativ zum Tischgestell zusätzlich verschiebbar gelagert sein, so daß die Tischplatte beispielsweise mit einer an einer Wand des Absorberraumes angebrachten Leiterschiene in sehr einfacher Weise in Kontakt gebracht werden kann. Die Tischplatte weist hierzu vorteilhaft an einer Stirnseite, vorzugsweise aber an zwei sich gegenüberliegenden Stirnseiten Kontaktelemente zur Kontaktierung der Leiterschiene auf. Die Kontaktelemente können vorteilhaft ein U-förmiges Profil aufweisen, in dem Kontaktfederelemente angeordnet sind, so daß die Kontaktelemente auf die Leiterschiene elektrisch kontaktierend aufgeschoben werden, wenn der Meßtisch an die Wand gerollt wird oder wenn die Tischplatte in dem Tischgestell zur Wand verschoben wird.

Vorteilhaft können Anschlußelemente der Streifenleiterstruktur in Aussparungen der Tischplatte angeordnet sein. Die Anschlußelemente können einen Anschlußstecker, beispielsweise einen 50-OHM-Koaxstecker aufweisen. Beim Schwenken der recht großen Tischplatte kommt es zu einer nicht unerheblichen Durchbiegung derselben. Um einer aus der damit verbundenen mechanischen Beanspruchung der Einspeisungsstelle der Streifenleiterstruktur möglicherweise resultierenden Beschädigung derselben vorzubeugen, ist es besonders vorteilhaft, wenn die Anschlußelemente der Streifenleiterstruktur einen Anschlußstecker aufweisen, der relativ zur Tischplatte beweglich an der Tischplatte angeordnet ist. Der Anschlußstecker kann vorteilhaft über federelastisch biegsame Mittel beweglich an der Tischplatte angeordnet sein.

### Zeichnungen

Ausführungsbeispiele der Erfindung sind in den Zeichnungen dargestellt und werden in der nachfolgenden Beschreibung erläutert.

Es zeigen
Fig. 1 eine perspektivische Ansicht eines Ausführungsbeispiels des Meßtisches,
Fig. 2 eine vergrößerte Detailansicht aus Fig. 1,
Fig. 3 ein erstes Ausführungsbeispiel der Anschlußelemente der Streifenleiterstruktur,
Fig. 4 ein zweites Ausführungsbeispiel der Anschlußelemente der Streifenleiterstruktur.

### Beschreibung der Ausführungsbeispiele

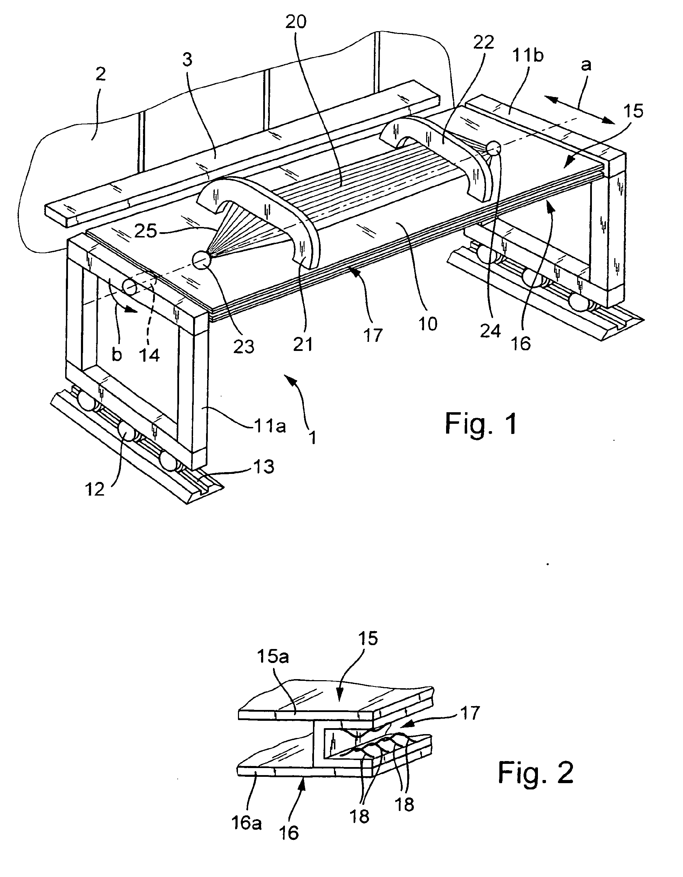

Fig. 1 zeigt ein Ausführungsbeispiel des erfindungsgemäßen Meßtisches 1. Der Meßtisch 1 weist eine Tischplatte 10 auf, die mittels zweier seitlicher Lagerbolzen 14 an einem Tischgestell 11 um ihre Längsachse schwenkbar gelagert ist (Pfeil b). Vorzugsweise ist die Tischplatte um 360° drehbar an dem Tischgestell angeordnet. Die Tischplatte weist zwei parallel zueinander verlaufende Hauptflächen 15 und 16 auf, die durch jeweils eine flächenförmige Leiterstruktur 15a und 16a, beispielsweise eine metallische Beschichtung oder Metallplatte gebildet werden. Ein zu vermessendes elektronisches Bauteil, beispielsweise ein elektronischer Schaltkreis, oder eine ganze Bauteilgruppe, beispielsweise ein mit elektronischen Bauteilen bestücktes Trägersubstrat, kann auf dem Meßtisch angeordnet und hinsichtlich der EMV-Eigenschaften vermessen werden.

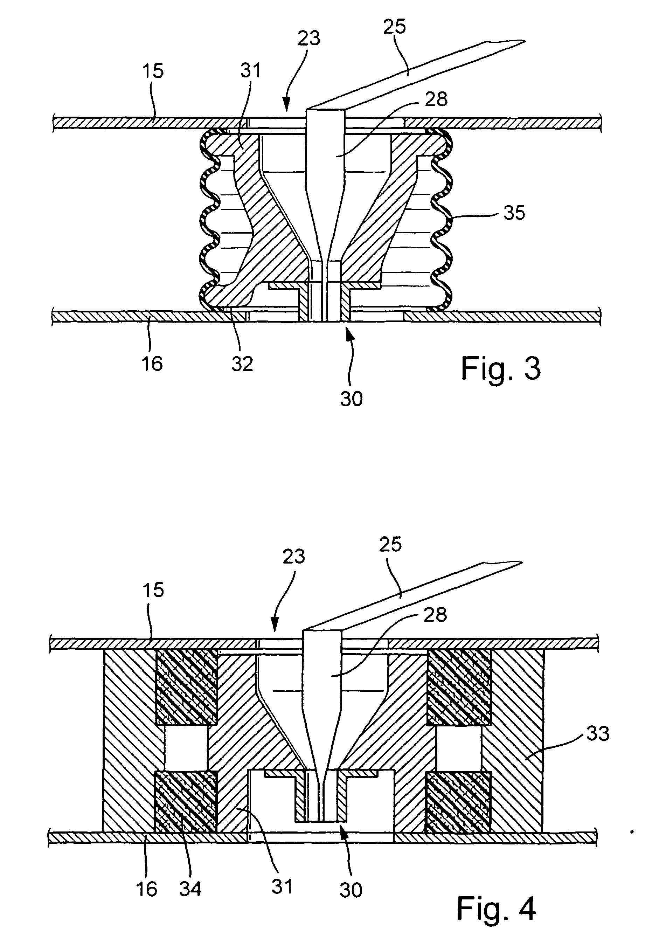

Auf der in der Fig. 1 nach oben gewandten Oberseite 15 sind Mittel 20 zur Durchführung einer elektromagnetischen Verträglichkeitsmessung einer ersten Art angeordnet. Die Mittel 20 umfassen beispielsweise eine Streifenleiterstruktur (Stripeline), welche mittels zweier isolierender Abstandhalter 21,22 parallel in einem Abstand zur Oberseite 15 montiert ist. Die isolierenden Abstandshalter 21,22 können preisgünstig aus Holz gefertigt werden und werden auf der Oberseite 16 des Meßtisches befestigt. Die Streifenleiterstruktur 20 weist in diesem Ausführungsbeispiel einen Streifenleiter definierter Breite auf, der über zwei seitliche, in etwa dreieckförmige Rampen 25 endseitig mit zwei Anschlußelementen 23,24 kontaktiert ist, die in Aussparungen der Tischplatte 10 angeordnet sind. Die Anschlußelemente 23,24 bilden jeweils zusammen mit den sie umgebenden Rändern der Aussparung in der Tischplatte 10 einen koaxialen Anschluß für die Enden der Streifenleiterstruktur 20. Die Anschlußelemente 23,24 sind in Fig. 3 und Fig. 4 genauer gezeigt, was weiter unten noch ausführlicher dargestellt ist.

Durch Schwenken der Tischplatte 10 um 180° gelangt die Unterseite 16 noch oben. Die Unterseite ist zur Durchführung einer elektromagnetischen Verträglichkeitsmessung einer zweiten Art geeignet ausgebildet. In dem hier dargestellten Ausführungsbeispiel weist die Unterseite 16 lediglich eine metallische Beschichtung 16a auf. Auf die nach oben gewandte Unterseite 16 können Meßapparaturen zur Durchführung einer Antennenabstrahlungs- und/oder Antenneneinstrahlungsmessung aufgebaut werden. Die nunmehr nach unten geschwenkte Streifenleiterstruktur kann diese Messungen der zweiten Art vorteilhaft nicht beeinflussen.

Das Tischgestell 11 ist in dem dargestellten Ausführungsbeispiel zweitteilig aufgebaut mit zwei seitlichen Rahmenteilen, die jeweils auf Rollen 12 fahrbar gelagert sind. Die Rollen können in einer Rollenführungsschiene 13 am Boden des Absorberraumes geführt sein. Es ist aber auch möglich, die Schwenkachse der Tischplatte 10 relativ zum Tischgestell 11 verschiebbar an dem Tischgestell 11 zu lagern, so daß das Tischgestell selbst nicht verschoben zu werden braucht. Durch die Verschiebbarkeit der Tischplatte 10 wird erreicht, daß die Tischplatte in Richtung des Pfeils a in Fig. 1 zur Wand hin verschiebbar ist.

Die Tischplatte 10 weist an zwei sich gegenüberliegenden Stirnseiten Kontaktteile 17 zur Kontaktierung einer an einer Wand 2 des Absorberraumes angeordneten Leiterschiene 3 auf. Durch Schwenken der Tischplatte 10 und aufschieben der Kontakteile 17 einer Stirnseite auf die Leiterschiene 3 kann die Tischplatte 10, falls dies für die Messung erforderlich ist, leitfähig mit der Wand des Absorberraumes verbunden werden. Die Kontaktteile 17 werden in diesem Ausführungsbeispiel durch jeweils eine in die Stirnseiten der Tischplatte 10 eingelassene Nut mit U-förmigen Profil gebildet, in dem Kontaktfederelemente 18 angeordnet sind, so daß die Kontaktteile 17 auf die Leiterschiene elektrisch kontaktierend aufsteckbar sind, wenn der Meßtisch 1 an die Wand 2 gerollt wird.

Die Anschlußelemente 23,24 der Streifenleiterstruktur weisen jeweils einen Anschlußstecker 30 auf, der vorzugsweise als 50-OHM-Koaxstecker ausgebildet ist. Die Anschlußenden 28 der Streifenleiterstruktur sind unter Berücksichtigung der Wellenwiderstandsanpassung in den Anschlußstecker 30 überführt, wobei die mit den Rampen 25 verbundenen Anschlußenden 28 je in einer Aussparung der Tischplatte 10 fixiert sind. Die Wellenwiderstandsanpassung erfolgt zwischen den Anschlußenden 28 und einem metallischen Hülsenteil 31, welches die Anschlußenden 28 umgibt und mit dem Mantelteil des 50-OHM-Koaxsteckers 30 verbunden ist. Das metallische Hülsenteil 31 ist relativ zur Tischplatte 10 beweglich an der Tischplatte angeordnet und über einen Hochfrequenzkontakt 32 mit der Tischplatte 10 leitend verbunden. Die Anschlußstecker 30 und das damit verbunde Hülsenteil 31 sind über federelastisch biegsame Mittel 35,34 beweglich an der Tischplatte 10 angeordnet. Als federelastisch biegsames Mittel kann beispielsweise, wie in Fig. 3 gezeigt, ein elastisch biegsames metallisches Wellrohr 35 oder, wie in Fig. 4 gezeigt, ein federelastisch wirkendes Metallgeflecht zwischen der Außenwand des Hülsenteils 31 und der Innenwand eines weiteren mit der Tischplatte 10 fest verbundenen Hülsenteils 33 dienen. Aber auch andere Ausführungsformen sind möglich. Durch die beweglich geführten Einspeisungsstellen der Streifenleiterstruktur wird eine Zerstörung der Hochfrequenzeinspeisungsstellen aufgrund einer Durchbiegung der Tischplatte 10 beim Schwenken vermieden.

## Patentansprüche

1. Meßtisch zur Durchführung von elektromagnetischen Verträglichkeitsmessungen an einem elektronischen Bauteil oder einer Bauteilgruppe, umfassend eine Tischplatte (10) mit auf der Oberseite (15) angeordneten Mitteln (20) zur Durchführung elektromagnetischer Verträglichkeitsmessungen einer ersten Art, **dadurch gekennzeichnet, daß** die Tischplatte (10) schwenkbar gelagert ist und eine nach oben schwenkbare Unterseite (16) zur Durchführung von weiteren elektromagnetischen Verträglichkeitsmessungen einer zweiten Art aufweist.

2. Meßtisch nach Anspruch 1, **dadurch gekennzeichnet, daß** die Mittel (20) zur Durchführung der elektromagnetischen Verträglichkeitsmessungen der ersten Art eine Streifenleiterstruktur umfassen.

3. Meßtisch nach Anspruch 1 oder 2, **dadurch gekennzeichnet, daß** die Unterseite (16) zur Durchführung von Antenneneinstrahlungs- und/oder Antennenabtrahlungsmessungen als Verträglichkeitsmessungen der zweiten Art geeignet ausgebildet ist.

4. Meßtisch nach Anspruch 1, **dadurch gekennzeichnet, daß** die Oberseite (15) und/oder Unterseite (16) mit je einer elektrisch leitfähigen Flächenleiterstruktur (15a,16a) versehen ist.

5. Meßtisch nach Anspruch 2, **dadurch gekennzeichnet, daß** die Streifenleiterstruktur (20) mit einem Abschnitt auf der Oberseite (16) der Tischplatte (10) weitgehend in einem Abstand parallel zur Oberseite angeordnet ist.

6. Meßtisch nach Anspruch 2 oder 5, **dadurch gekennzeichnet, daß** Anschlußelemente (23,24) der Streifenleiterstruktur in Aussparungen der Tischplatte (10) angeordnet sind.

7. Meßtisch nach Anspruch 6, **dadurch gekennzeichnet, daß** die Anschlußelemente (23,24) einen Anschlußstecker (30), vorzugsweise einen 50-OHM-Koaxstecker aufweisen, der relativ zur Tischplatte (10) beweglich an der Tischplatte angeordnet ist.

8. Meßtisch nach Anspruch 7, **dadurch gekennzeichnet, daß** der Anschlußstecker (30) über federelastisch biegsame Mittel (35,34) beweglich an der Tischplatte (10) angeordnet ist.

9. Meßtisch nach Anspruch 7 oder 8, **dadurch gekennzeichnet, daß** der Anschlußstecker (30) über einen Hochfrequenzkontakt (32) mit der Tischplatte leitend verbunden ist.

10. Meßtisch nach Anspruch 1, **dadurch gekennzeichnet, daß** die Tischplatte (10) an einem Tischgestell (11) schwenkbar gelagert ist.

11. Meßtisch nach Anspruch 10, **dadurch gekennzeichnet, daß** das Tischgestell (11) auf Rollen (12) fahrbar gelagert ist.

12. Meßtisch nach Anspruch 10, **dadurch gekennzeichnet, daß** die Schwenkachse der Tischplatte (10) relativ zum Tischgestell (11) verschiebbar an dem Tischgestell gelagert ist.

13. Meßtisch nach einem der vorstehenden Ansprüche, **dadurch gekennzeichnet, daß** die Tischplatte (10) an einer Stirnseite, vorzugsweise aber an zwei sich gegenüberliegenden Stirnseiten Kontaktteile (17) zur Kontaktierung einer an einer Wand (2) angeordneten Leiterschiene (3) aufweist.

14. Meßtisch nach Anspruch 13, **dadurch gekennzeichnet, daß** die Kontaktteile (17) ein in die Stirnseite eingelassenes U-förmiges Profil aufweisen, in dem Kontaktfederelemente (18) angeordnet sind, so daß die Kontaktteile (17) auf die Leiterschiene elektrisch kontaktierend aufsteckbar sind.

## Claims

1. Measuring table for carrying out electromagnetic compatibility measurements on an electronic component or a group of components, said table comprising a table plate (10) with means (20) which are arranged on the top side (15) and are intended to carry out a first type of electromagnetic compatibility measurements, **characterized in that** the table plate (10) is pivotably mounted and has an underside (16) which can be pivoted upwards and is intended to carry out a second type of further electromagnetic compatibility measurements.

2. Measuring table according to Claim 1, **characterized in that** the means (20) for carrying out the first type of electromagnetic compatibility measurements comprise a stripline structure.

3. Measuring table according to Claim 1 or 2, **characterized in that** the underside (16) is suitably designed to carry out antenna irradiation and/or antenna transmission measurements as the second type of compatibility measurements.

4. Measuring table according to Claim 1, **characterized in that** the top side (15) and/or underside (16) is/are provided with a respective electrically conductive area conductor structure (15a, 16a).

5. Measuring table according to Claim 2, **characterized in that** one section of the stripline structure (20) is arranged on the top side (16) of the table plate (10) largely at a distance parallel to the top side.

6. Measuring table according to Claim 2 or 5, **characterized in that** connecting elements (23, 24) of the stripline structure are arranged in recesses of the table plate (10).

7. Measuring table according to Claim 6, **characterized in that** the connecting elements (23, 24) have a connecting plug (30), preferably a 50 ohm coaxial connector, which is arranged on the table plate such that it can be moved relative to the table plate (10).

8. Measuring table according to Claim 7, **characterized in that** the connecting plug (30) is arranged on the table plate (10) such that it can be moved using resiliently flexible means (35, 34).

9. Measuring table according to Claim 7 or 8, **characterized in that** the connecting plug (30) is conductively connected to the table plate by means of a radio-frequency contact (32).

10. Measuring table according to Claim 1, **characterized in that** the table plate (10) is pivotably mounted on a table stand (11).

11. Measuring table according to Claim 10, **characterized in that** the table stand (11) is movably mounted on rollers (12).

12. Measuring table according to Claim 10, **characterized in that** the pivot axis of the table plate (10) is mounted on the table stand such that it can be displaced relative to the table stand (11).

13. Measuring table according to one of the preceding claims, **characterized in that** the table plate (10) has, on one end side but preferably on two opposite end sides, contact parts (17) for contact-connecting a conductor rail (3) which is arranged on a wall (2).

14. Measuring table according to Claim 13, **characterized in that** the contact parts (17) have a U-shaped profile which is embedded in the end side and in which contact spring elements (18) are arranged, with the result that the contact parts (17) can be pushed onto the conductor rail in an electrically contact-connecting manner.

## Revendications

1. Table de mesure pour effectuer des mesures de compatibilité électromagnétique sur une pièce électronique ou un groupe de pièces comprenant un plateau (10) dont la face supérieure (15) comporte des moyens (20) pour effectuer des mesures de compatibilité électromagnétique d'un premier type,
**caractérisée en ce que**
le plateau (10) est pivotant et a une face inférieure (16) qui peut être pivotée vers le haut pour effectuer d'autres mesures de compatibilité électromagnétique d'un second type.

2. Table de mesure selon la revendication 1,
**caractérisée en ce que**
les moyens (20) pour effectuer les mesures de compatibilité électromagnétique du premier type comprennent une structure de rubans conducteurs.

3. Table de mesure selon la revendication 1 ou 2,
**caractérisée en ce que**
la face inférieure (16) est réalisée pour effectuer les mesures de compatibilité du second type qui sont des mesures de rayonnement d'émission et/ou de réception d'antenne.

4. Table de mesure selon la revendication 1,
**caractérisée en ce que**
la face supérieure (15) et/ou la face inférieure (16) sont munies chacune d'une structure électroconductrice de conducteurs en surface (15a, 16a).

5. Table de mesure selon la revendication 2,
**caractérisée en ce que**
la structure de rubans conducteurs (20) a un segment sur la face supérieure (16) du plateau (10), très largement distante parallèlement à la surface supérieure.

6. Table de mesure selon la revendication 2 ou 5,
**caractérisée en ce que**
des éléments de branchement (23, 24) de la structure de ruban conducteurs sont dans des cavités du plateau (10).

7. Table de mesure selon la revendication 6,
**caractérisée en ce que**
les éléments de branchement (23, 24) comportent un connecteur (30), de préférence un connecteur coaxial 50-ohms, mobile sur le plateau par rapport au plateau (10).

8. Table de mesure selon la revendication 7,
**caractérisée en ce que**
le connecteur (30) est monté de manière mobile sur le plateau (10) par l'intermédiaire de moyens souples (35, 34) élastiques comme des ressorts.

9. Table de mesure selon la revendication 7 ou 8,
**caractérisée en ce que**
le connecteur (30) est relié de façon conductrice au plateau par un contact haute fréquence (32).

10. Table de mesure selon la revendication 1,
**caractérisée en ce que**
le plateau (10) est monté pivotant sur un bâti (11).

11. Table de mesure selon la revendication 10,
**caractérisée en ce que**
le bâti (11) est monté mobile sur des galets (12).

12. Table de mesure selon la revendication 10,
**caractérisée en ce que**
l'axe de pivotement du plateau (10) par rapport au bâti (11) est coulissant par rapport au bâti.

13. Table de mesure selon l'une des revendications précédentes,
**caractérisée en ce qu'**
une face frontale du plateau (10) et de préférence les deux faces frontales opposées comportent des pièces de contact (17) pour la mise en contact d'un rail conducteur (3) prévu sur une paroi (2).

14. Table de mesure selon la revendication 13,
**caractérisée en ce que**
les pièces de contact (17) ont un profil en forme de U intégré dans la face frontale, et dans lequel se trouvent des éléments de ressort de contact (18) pour que les pièces de contact (17) puissent être enfichées avec contact électrique sur les rails conducteurs.
